# EUROPÄISCHE PATENTSCHRIFT

(11) **EP 1 389 405 B1**
(45) Veröffentlichungstag und Bekanntmachung des Hinweises auf die Patenterteilung: **17.11.2004**
(21) Anmeldenummer: 02771623.2
(22) Anmeldetag: 03.05.2002
(51) Int. Cl.: H05K 3/00, B23K 26/38

(54) **VERFAHREN ZUM BOHREN VON MIKROLÖCHERN MIT EINEM LASERSTRAHL**
METHOD FOR DRILLING MICROHOLES USING A LASER BEAM
PROCEDE POUR PERCER DES MICRO-TROUS AU MOYEN D'UN FAISCEAU LASER

(30) Priorität: 23.05.2001 DE 10125397
(43) Veröffentlichungstag der Anmeldung: 18.02.2004
(73) Patentinhaber: SIEMENS AKTIENGESELLSCHAFT, 80333 München (DE)
(72) Erfinder: HEERMAN, Marcel, B-9200 Merelbeke (BE); ROELANTS, Eddy, B-8000 Bruegge (BE); DE STEUR, Hubert, B-9031 Drogen (BE); EDM , Sébastian, F-59320 Radinghem-Wennes (FR)
(86) Internationale Anmeldenummer: PCT/DE2002/001612
(87) Internationale Veröffentlichungsnummer: WO 2002/096167

(56) Entgegenhaltungen:
- US-A- 5 593 606
- US-A- 5 841 099

## Beschreibung

Die Erfindung betrifft ein Verfahren zum Bohren von Mikrolöchern in einem Mehrschichtsubstrat mit einer ersten und mindestens einer zweiten Metallschicht und mit jeweils einer zwischen zwei Metallschichten angeordneten Dielektrikumsschicht durch Bestrahlung mit dem Energiestrahl eines Festkörperlasers, wobei die Bestrahlung in zwei Stufen derart erfolgt, daß in der ersten Stufe jeweils die erste Metallschicht und ein Teil der darunterliegenden Dielektrikumsschicht und daß in der zweiten Stufe die Dielektrikumsschicht sauber bis auf die zweite Metallschicht abgetragen wird.

Im Zuge der Miniaturisierung von elektrischen Schaltungssubstraten ist es zunehmend erforderlich, sowohl Durchgangslöcher als auch Sacklöcher mit Durchmessern von weniger als 200 µm zu erzeugen, die kaum noch mit mechanischen Bohrern oder Stanznadeln erzeugt werden können. In diesem Bereich ist es schon lange üblich, Mikrolöcher mittels Laserbohren herzustellen. Allerdings ergibt sich dabei das Problem, daß die unterschiedlichen Materialien, also Leitermaterialien, wie Kupfer, einerseits und Dielektrika, wie etwa Polymere mit und ohne Glasfaserverstärkung, andererseits gänzlich unterschiedliche Anforderungen an die Laserbearbeitung stellen. So ist es durchaus bekannt, welche Laser in welchem Wellenlängenbereich optimal für das Bohren in Metallen oder für das Bohren in Kunststoffen geeignet sind. Probleme treten dann auf, wenn Mehrschichtsubstrate mit ein und demselben Laser durchgebohrt oder zur Herstellung einer leitenden Verbindung zu einer metallischen Zwischenlage mit Sacklöchern versehen werden sollen. Beim Bohren derartiger unterschiedlicher Materialschichten können negative thermische Effekte auftreten, wie beispielsweise Ablöseeffekte zwischen Metallschichten und Dielektrikumsschichten, Schädigung des Dielektrikums selbst oder ein unbeabsichtigtes Durchbohren einer Metallschicht, die mit einem Sackloch kontaktiert werden soll.

In der US 5 593 606 A ist ein Verfahren zum Bohren von Mikrolöchern in einem Mehrschichtsubstrat beschrieben, bei dem mittels eines UV-Lasers mit ein und derselben Dimensionierung mindestens zwei Schichten mit unterschiedlichen Eigenschaften vollständig durchgebohrt werden sollen. Wenn allerdings der Laserstrahl so dimensioniert ist, daß er eine erste Metallschicht durchbohrt und danach eine Dielektrikumsschicht vollständig abträgt, besteht ohne weiteres die Gefahr, daß er an der zweiten Metallschicht nicht rechtzeitig zum Stehen kommt und daß dabei die zweite Metallschicht mehr oder weniger mit angegriffen wird, wenn nicht durch entsprechende Meßeinrichtungen das Erreichen der gewünschten Bohrtiefe festgestellt und der Bohrvorgang rechtzeitig gestoppt wird.

Um diesem Problem zu begegnen, wird in der US 5 841 099 (bester Stand der Technik) ein zweistufiges Verfahren (beim Bohren von zwei Schichten) vorgeschlagen, wobei der Laser in einer ersten Stufe zum Bohren einer ersten Metallschicht auf eine höhere Energiedichte eingestellt wird und wobei in der zweiten Stufe zum Bohren einer Dielektrikumsschicht die Energiedichte des Lasers soweit gesenkt wird, daß die Schwelle zur Verdampfung von Metall unterschritten wird. Damit kann der Laser aufgrund seiner niedrigeren Energiedichte eine an die Dielektrikumsschicht angrenzende zweite Metallschicht nicht mehr durchbohren. Um diese niedrigere Energiedichte in der zweiten Stufe einzustellen, wird dort vorgeschlagen, die Wiederholrate des Lasers zu erhöhen. Allerdings erhält man auf diese Weise keine optimale Ausnutzung der Laserenergie und keine optimale Bearbeitungsgeschwindigkeit.

Ziel der vorliegenden Erfindung ist es deshalb, das eingangs genannte zweistufige Verfahren zum Bohren von Mikrolöchern mittels eines Lasers so zu gestalten, daß die Mikrolöcher in guter Qualität und mit möglichst hoher Bearbeitungsgeschwindigkeit unter optimaler Ausnutzung der Laserleistung erzeugt werden können.

Erfindungsgemäß wird dieses Ziel mit einem Verfahren gemäß Anspruch 1 bzw. Anspruch 10 erreicht.

Bei dem erfindungsgemäßen Verfahren wird also nicht wie beim Stand der Technik zur Verringerung der wirksamen Energiedichte beim Abtragen des Dielektrikums in der zweiten Stufe die Wiederholfrequenz erhöht, sondern vorzugsweise gesenkt oder allenfalls auf gleichem Wert gehalten wie in der ersten Stufe. Die Verringerung der wirksamen Energiedichte erfolgt vielmehr durch Defokussierung und damit durch eine Vergrößerung des Fleckdurchmessers, auf den der Laserstrahl auftrifft, und außerdem durch eine Erhöhung der Umlaufgeschwindigkeit, wodurch die Einwirkungszeit der einzelnen Laserimpulse auf eine bestimmte Fläche verkürzt wird.

Für das Bohren des Loches in der Metallschicht (Kupferschicht) in der ersten Stufe genügt in der Regel, daß der Laser in einem einzigen Kreis entsprechend dem Durchmesser des gewünschten Loches so oft bewegt wird, bis die Metallschicht kreisförmig ausgeschnitten ist. Bei Durchmessern bis zu 150 µm löst sich dann der ausgeschnittene Metallkern aufgrund des Wärmeeffekts von selbst und springt heraus. Bei größeren Lochdurchmessern kann ein zusätzlicher Impuls zur Erwärmung auf den freigeschnittenen Metallkern gegeben werden.

Um einen sauberen Lochrand in der Metallschicht zu erzielen, wird in der ersten Stufe des Laserbohrens eine hohe Überlappung (> 50%) der Einzelimpulse, die den Kreis bilden, angestrebt. Zu diesem Zweck wählt man für diese erste Stufe eine höhere Wiederholfrequenz von mindestens 15 kHz, vorzugsweise zwischen 20 und 30 kHz. In diesem Bereich liefern die verfügbaren Laser zwar nicht mehr die maximale mittlere Leistung. Doch wird vorzugsweise ein Neodymium-Vanadat-Laser (Nd:VO₄-Laser) verwendet, bei dem der Leistungsabfall bei höheren Wiederholfrequenzen noch relativ gering ist. So kann bei einem 355 nm-Nd-Vanadat-Laser von 3,5 W mit einem Brennfleckdurchmesser von 12 µm eine lineare Umlaufgeschwindigkeit von > 175 mm/s erreicht werden. Bei Lasern mit höherer Leistung können aufgrund höherer Wiederholfrequenzen auch noch höhere Geschwindigkeiten erreicht werden. Entsprechend gut einsetzbar ist auch ein Neodym-Vanadat-Laser mit einer Wellenlänge von 532 nm.

In der zweiten Stufe kann das dielektrische Material durch Führen des Lasers in mindestens zwei konzentrischen Kreisen abgetragen werden, wobei in diesem Fall keine Überlappung der aufeinanderfolgenden Laserpulse erforderlich ist. Hier wird die Wiederholfrequenz annähernd so gewählt, daß die maximal verfügbare Laserleistung zum Materialabtrag ausgenutzt wird. Diese maximale Leistung ergibt sich bekanntlich bei einer etwas geringeren Wiederholfrequenz, beim Nd:VO₄-Laser also bei etwa 10 bis 20 kHz. Die Anpassung der wirksame Energiedichte auf einen Wert unterhalb der Verdampfungsschwelle für Metall erfolgt in diesem Fall, wie erwähnt, durch Vergrößerung des bestrahlten Fleckdurchmessers, also durch eine Defokussierung bzw. durch eine Veränderung des Vergrößerungsfaktors des Kollimators. Zusätzlich wird vorzugsweise die Umlaufgeschwindigkeit derart erhöht, daß die einzelnen Pulse nicht mehr nur auf einen dem Strahldurchmesser entsprechenden Fleck treffen, sondern ihre Energie durch einen Schmiereffekt auf eine größere Fläche verteilen.

Bei Verwendung eines Nd-Vanadat-Lasers mit höherer Leistung ist es auch denkbar, in der zweiten Stufe den Laserstrahl nicht im Kreis umlaufen zu lassen, sondern den Strahl soweit aufzuweiten, daß er die gesamte Lochfläche überdeckt. In diesem Fall wird das Dielektrikum mit einer zentralen Einstellung des Strahls abgetragen, wobei das in der ersten Stufe aus der Metallschicht ausgeschnittene Loch als Maske dient.

Die Erfindung wird nachfolgend an Ausführungsbeispielen anhand der Zeichnung näher erläutert. Es zeigen
Figur 1 eine schematisch gezeigte Laseranordnung mit einer Einstellung für die erste Stufe des erfindungsgemäßen Verfahrens,
Figur 2 die Laseranordnung von Figur 1 mit einer Einstellung für die zweite Stufe des erfindungsgemäßen Verfahrens,
Figur 3A bis 3C eine Schnittdarstellung eines Substrats in verschiedenen Verfahrensstadien beim Bohren eines Mikroloches in einer ersten Ausführungsform des erfindungsgemäßen Verfahrens,
Figur 4 eine schematische Darstellung der Führung des Laserstrahls in der ersten Stufe des erfindungsgemäßen Verfahrens zur Erzeugung des Loches gemäß Figur 3A und 3B,
Figur 5 eine schematische Darstellung der Führung des Laserstrahls in der zweiten Stufe des erfindungsgemäßen Verfahrens zur Erzeugung des Loches gemäß Figur 3C,
Figur 6A bis 6C einen Schnitt durch ein Substrat in verschiedenen Stadien bei der Erzeugung eines Mikroloches in einer zweiten Ausführungsform des erfindungsgemäßen Verfahrens,
Figur 7 eine schematische Darstellung der Laserstrahlführung zur Erzeugung eines Mikroloches in einer Metallschicht gemäß Figuren 6A und 6B,
Figur 8 die schematische Darstellung der Laserstrahlführung in einer Dielektrikumsschicht zur Erzeugung eines Mikroloches gemäß Figur 6C,
Figur 9 ein Diagramm zur Darstellung der mittleren Ausgangsleistung verschiedener Halbleiterlaser in Abhängigkeit von der Wiederholfrequenz und
Figur 10 ein Diagramm zur Darstellung der mittleren Ausgangsleistung und der Pulsbreite eines Neodym-Vanadat-Lasers mit 355 nm Wellenlänge in Abhängigkeit von der Pulswiederholfrequenz.

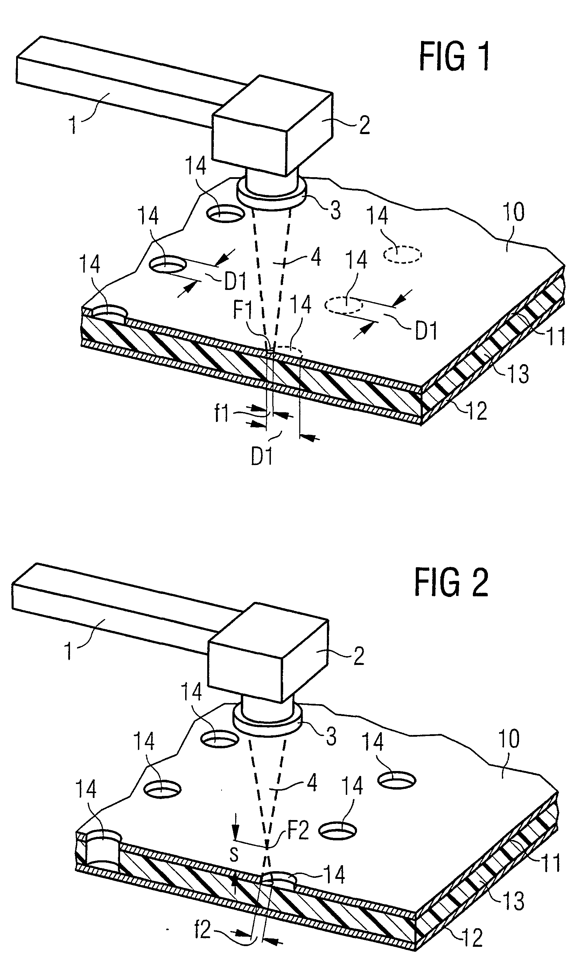

Die in den Figuren 1 und 2 schematisch und keineswegs maßstabgerecht gezeigte Anordnung zeigt einen Laser 1 mit einer Ablenkeinheit 2 und einer optischen Abbildungseinheit 3, über die ein Laserstrahl 4 auf ein Substrat 10 gerichtet wird. Dieses Substrat 10 besitzt eine obere, erste Metallschicht (Kupferschicht) 11 sowie eine zweite Metallschicht 12, zwischen denen eine Dielektrikumsschicht 13 angeordnet ist. Diese Dielektrikumsschicht besteht beispielsweise aus einem Polymermaterial wie RCC oder einem glasfaserverstärkerten Polymermaterial, wie FR4. Während die Metallschicht, die in der Regel aus Kupfer besteht, immer die gleiche Energiemenge zur Bearbeitung bzw. Abtragung (bei gleicher Dicke und gleichem Volumen) erfordert, hängt die benötigte Energiemenge beim Dielektrikum stark von dessen Zusammensetzung ab. Erwähnt sei noch, daß das Substrat 10 auch aus mehr als den genannten drei Schichten bestehen kann, wobei weitere Metallschichten jeweils durch Dielektrikumsschichten voneinander getrennt sind und wahlweise durch entsprechende Bohrungen miteinander und mit der obersten Metallschicht 11 verbunden werden können.

Im vorliegenden Beispiel geht es darum, die erste Metallschicht 11 durch Sacklöcher 14 mit der zweiten Metallschicht 12 zu verbinden, ohne daß die Schicht 12 durchgebohrt wird. Diese Löcher 14 sollen beispielsweise einen Durchmesser von etwa 100 bis 120 µm haben. Sie können aber auch größer oder kleiner sein.

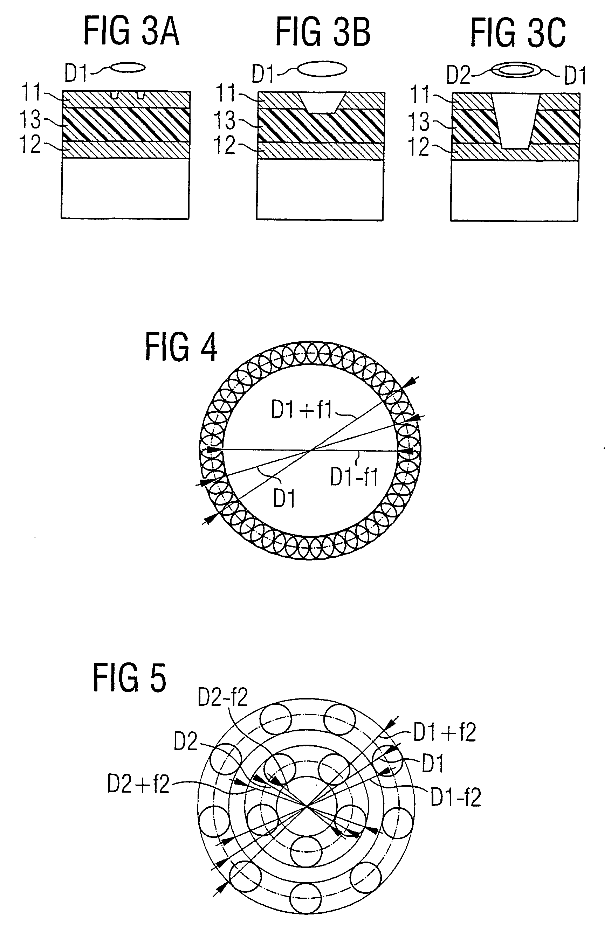

Erfindungsgemäß erfolgt die Bohrung der Löcher in zwei Stufen. Figur 1 zeigt die Anordnung für die erste Stufe, wobei der Laserstrahl 4 auf einen Brennpunkt F1 auf der Oberfläche der Schicht 11 fokussiert wird. Die Energie des Laserstrahls wird dabei auf einen Fleck (Spot) mit einem Durchmesser f1 gerichtet, um die Energie möglichst konzentriert zum Abtrag der Metallschicht 11 einzusetzen. Dabei wird der Laserstrahl in einem Kreis mit dem Durchmesser D1 bewegt, wie dies in Figur 4 gezeigt ist. Die Umlaufgeschwindigkeit in diesem Kreis D1 ist so gewählt, daß sich die einzelnen Impulse beispielsweise mit mehr als 60% überlappen. Auf diese Weise wird ein glatter Rand aus der Metallschicht geschnitten. Je nach Dicke der Metallschicht ist eine bestimmte Anzahl von Kreisumläufen erforderlich, bis diese vollständig durchschnitten ist. Die Figuren 3A und 3B zeigen den zeitlichen Verlauf dieser Stufe 1 in verschiedenen Stadien. Das Metall wird ringförmig gemäß Figur 3A ausgeschnitten, bis die Metallschicht durchtrennt ist. Danach springt (zumindest bei Lochdurchmessern < 150 µm) der abgetrennte Kern aufgrund des Wärmeeffekts von selbst heraus, so daß der Zustand von Figur 3B entsteht.
Nach dem Durchbohren der Metallschicht 11 wird der Laser gemäß Figur 2 so eingestellt, daß der Brennpunkt F2 außerhalb des zu bohrenden Lochbereiches liegt, also beispielsweise s=2 mm oberhalb der Kupferschicht 12. Im Bereich der zu bohrenden Schicht trifft der Laserstrahl somit auf einen Fleck mit dem Durchmesser f2. Außerdem wird die Wiederholfrequenz vorzugsweise verringert, um die maximale Laserenergie zu nutzen. Der so eingestellte Laserstrahl wird nun wiederum im Kreis bewegt, und zwar zunächst wieder in einem Kreis mit dem Durchmesser D1, danach in einem konzentrischen Kreis mit dem Durchmesser D2. Für normale Lochdurchmesser und Materialstärken genügen dabei wenige Umläufe, um auf diese Weise das Dielektrikumsmaterial bis auf die zweite Metallschicht 12 vollständig und sauber abzutragen. Auch wenn bei den Umläufen des Laserstrahls nicht die gesamte Lochfläche überstrichen wird, wird doch der Rest des Dielektrikums aufgrund der Wärmeentwicklung mit verdampft. Je nach den Materialien, Materialstärken und dem gewünschten Lochdurchmesser können natürlich auch mehr konzentrische Kreise mit dem Laserstrahl ausgeführt werden. Die Umlaufgeschwindigkeit wird dabei so gewählt, daß die wirksame Energiedichte unterhalb der Schwelle für die Verdampfung der zweiten Metallschicht 12 liegt. Es entsteht schließlich ein Blindloch 14 gemäß Figur 3C.

Wie anhand der Figuren 1 und 2 erkennbar ist, wird zunächst für alle Bohrungen 14 die erste Stufe ausgeführt, d.h., daß für alle vorgesehenen Löcher zunächst die Metallschicht durchbohrt wird, so daß der Zustand gemäß Figur 3B erreicht wird. Danach wird der Laser auf die Stufe 2 eingestellt, und alle Löcher werden durch Abtragen der Dielektrikumsschicht fertiggestellt.

Für das in den Figuren 3A bis 3C sowie 4 und 5 dargestellte Beispiel wurden Bohrungen mit einem Nd:VO₄-Laser einer Wellenlänge von 355 nm durchgeführt, und zwar mit einem Durchmesser von 110 µm. Dabei wurde unter folgenden Bedingungen gearbeitet:

| **Bedingung** | **Stufe 1** | **Stufe 2** |
|---|---|---|
| Material/Dicke | Cu/12µm | RCC/65-70 µm |
| Anzahl der Kreisdurchmesser | 1 | 2 |
| Kreisumläufe | 4 | 2 |
| Umlaufgeschwindigkeit | 200 mm/s | 400 mm/s |
| Wiederholfrequenz | 30 kHz | 10 kHz |
| Fokus | auf (erste) Metallschicht 11 | 2 mm oberhalb Metallschicht 11 |
| Fleckdurchmesser | 13 µm | 20 µm |
| Energie/Puls | 0,11 mJ | 0,32 mJ |
| Gesamtenergiedichte (über die Bohrzeit pro Loch aufsummiert) | 525 J/cm² | 84 J/cm² |

Bei dieser Einstellung wurde für die erste Stufe eine Ausbeute von 130 Bohrungen pro Sekunde und in der zweiten Stufe eine Ausbeute von 305 Löchern pro Sekunde erzielt.

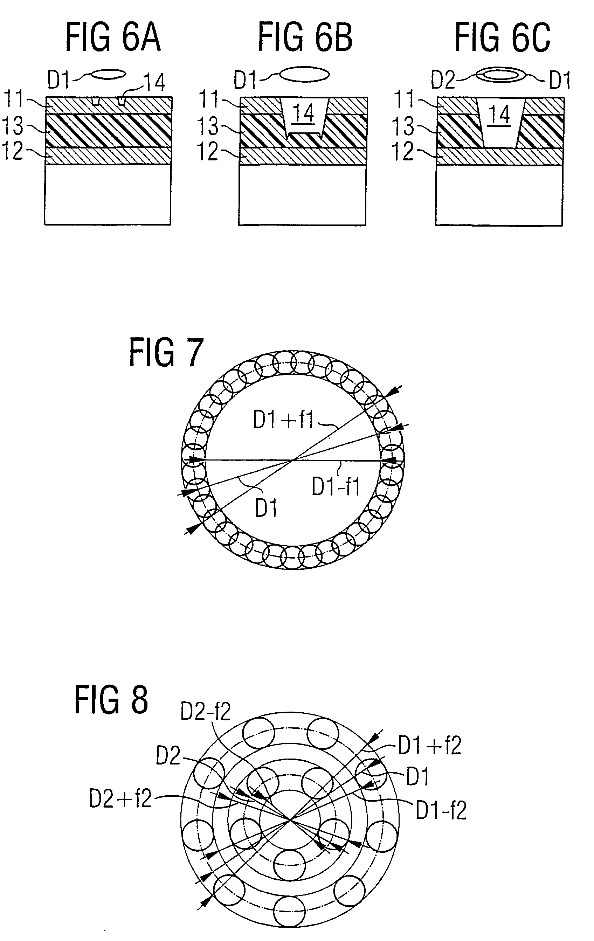

Ein weiteres Beispiel mit etwas abgewandelter Einstellung sei anhand der Figuren 6A bis 6C, 7 und 8 erläutert. Wie im vorhergehenden Beispiel besteht die Metallschicht wiederum aus Kupfer, während die Dielektrikumsschicht nunmehr aus mit Glasfaser verstärktem FR4 besteht. Um auch in diesem Fall das Loch möglichst effektiv zu erzeugen, werden in der Stufe 1 mehr Umläufe des Laserstrahls 4 angewandt, als allein für das Durchschneiden der Metallschicht 11 notwendig wäre. Auf diese Weise wird bereits in der ersten Stufe tief in die Dielektrikumsschicht 12 eingeschnitten, zumindest im Randbereich (Figur 6B). Um eine möglichst hohe Laserenergie zur Verfügung zu haben, wird in diesem Fall die Wiederholfrequenz niedriger gewählt, nämlich 20 kHz. Dadurch überschneiden sich die einzelnen Pulse weniger als im vorhergehenden Beispiel, wie in Figur 7 im Vergleich zu Figur 4 zu sehen ist. Dies wird aber durch die größere Zahl von Umläufen ausgeglichen, so daß trotzdem im Kupfer ein glatter Rand entsteht. In der zweiten Stufe ist der Laser auf die gleiche Wiederholfrequenz von 10 kHz wie im ersten Beispiel eingestellt. Allerdings genügt hier bereits ein Umlauf des Laserstrahls (in zwei konzentrischen Kreisen D1 und D2), um den verbleibenden Rest des Dielektrikums abzutragen. Im einzelnen galten bei diesem Beispiel folgende Werte:

| **Bedingung** | **Stufe 1** | **Stufe 2** |
|---|---|---|
| Material/Dicke | Cu/12 µm | FR4/65-70 µm |
| Anzahl der Kreisdurchmesser | 1 | 2 |
| Kreisumläufe | 7 | 1 |
| Umlaufgeschwindigkeit | 200 m/s | 400 mm/s |
| Wiederholfrequenz | 20 kHz | 10 kHz |
| Fokus | auf erster Metallschicht 11 | 2 mm oberhalb Metallschicht 11 |
| Fleckdurchmesser | 13 µm | 20 µm |
| Energie/Puls | 0,19 mJ | 0,32 mJ |
| Gesamtenergiedichte | 1036 j/cm² | 42 J/cm² |

Bei diesem zweiten Beispiel konnte für die erste Stufe eine Ausbeute von 77 Bohrungen pro Sekunde und in der zweiten Stufe eine Ausbeute von 543 Bohrungen pro Sekunde erzielt werden.

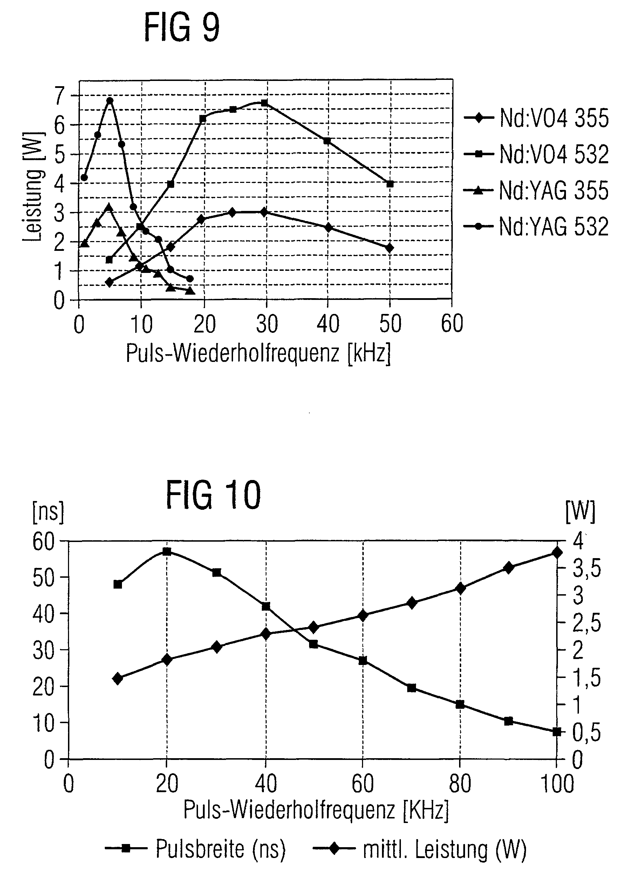

In Figur 9 sind die Nd:VO₄-Laser mit 355 nm bzw. 532 nm den entsprechenden Nd:YAG-Lasern hinsichtlich ihrer Leistung bei bestimmten Wiederholfrequenzen gegenübergestellt. Dabei wird deutlich, daß die Nd:VO4-Laser in ihrer mittleren Leistung oberhalb von 10 kHz Wiederholfrequenz deutlich ansteigen und ihr Maximum zwischen 20 und 30 kHz erreichen, während die Nd:YAG-Laser ihr Maximum bei 5 kHz haben und danach stark abfallen. Daraus wird deutlich, daß die Nd:VO₄-Laser für das erfindungsgemäße Verfahren deutliche Vorteile bieten.

Figur 10 zeigt noch einmal den Verlauf der Leistung zusammen mit der Pulsbreite in Abhängigkeit von der Wiederholfrequenz für einen Nd:VO₄-Laser mit 355 nm Wellenlänge. Daraus wird deutlich, daß in dem vorzugsweise benutzten Bereich der Wiederholfrequenz zwischen 10 und 40 kHz einerseits die mittlere Ausgangsleistung des Lasers im maximalen Bereich liegt, während die Pulsbreite unterhalb von etwa 35 ns liegt.

## Patentansprüche

1. Verfahren zum Bohren von Mikro-Löchern (14)in einem Mehrschicht-Substrat (10) mit einer ersten (11) und mindestens einer zweiten (12) Metallschicht und mit jeweils einer zwischen zwei Metallschichten angeordneten Dielektrikumsschicht (13) durch Bestrahlung mit dem Energiestrahl eines Festkörperlasers (1) mit einer Wiederholfrequenz von mindestens 10 kHz, einer Wellenlänge von weniger als 1100 nm und einer Pulslänge von weniger als 50 ns, wobei die Bestrahlung in zwei Stufen derart erfolgt, daß in der ersten Stufe jeweils die erste Metallschicht und ein Teil der darunterliegenden Dielektrikumsschicht und daß in der zweiten Stufe die Dielektrikumsschicht sauber bis auf die zweite Metallschicht abgetragen wird, mit folgenden Schritten:
- in der ersten Stufe wird der Laserstrahl (4) auf eine Wiederholfrequenz von mindestens 15 kHz eingestellt, auf die erste Metallschicht (11) fokussiert und mit einer ersten Umlaufgeschwindigkeit in einem Kreis entsprechend dem Durchmesser (D1) des gewünschten Loches in so vielen Durchgängen bewegt, bis zumindest die erste Metallschicht (11) durchschnitten ist, wobei die Metallschicht im Lochbereich vollständig entfernt wird, und
- in der zweiten Stufe wird der Laserstrahl (4) auf eine gleiche oder geringere Wiederholrate wie in der ersten Stufe eingestellt, außer Fokus auf die im Loch (14) freigelegte Dielektrikumsschicht (13) gerichtet und mit einer Umlaufgeschwindigkeit, die höher ist als die erste, in einem (D1) oder mehreren (D2) konzentrischen Kreisen innerhalb des gewünschten Lochdurchmessers in so vielen Durchgängen bewegt, bis die Dielektrikumsschicht im Lochbereich abgetragen ist, wobei die Defokussierung (s) und die zweite Umlaufgeschwindigkeit derart eingestellt werden, daß die wirksame Energiedichte in der zweiten Stufe unterhalb der Schwelle für eine Abtragung der zweiten Metallschicht liegt.

2. Verfahren nach Anspruch 1,
**dadurch gekennzeichnet, daß** ein Neodymium-Vanadat-Laser mit einer Wellenlänge von 355 nm verwendet wird.

3. Verfahren nach Anspruch 1,
**dadurch gekennzeichnet, daß** ein Neodymium-Vanadat-Laser mit einer Wellenlänge von 532 nm verwendet wird.

4. Verfahren nach Anspruch 1 oder 2,
**dadurch gekennzeichnet, daß** die Wiederholfrequenz in der ersten Stufe zwischen etwa 15 kHz und etwa 40 kHz und in der zweiten Stufe zwischen etwa 10 kHz und 20 kHz eingestellt wird, wobei die Wiederholfrequenz in der zweiten Stufe immer gleich oder niedriger ist als in der ersten Stufe.

5. Verfahren nach einem der Ansprüche 1 bis 4,
**dadurch gekennzeichnet, daß** die Wiederholfrequenz in beiden Stufen auf 15 kHz eingestellt wird.

6. Verfahren nach einem der Ansprüche 1 bis 5,
**dadurch gekennzeichnet, daß** die Umlaufgeschwindigkeit des Laserstrahls (4) in der ersten Stufe zwischen 200 und 300 mm/s und in der zweiten Stufe zwischen 200 und 600 mm/s beträgt, in jedem Fall aber höher ist als in der ersten Stufe.

7. Verfahren nach einem der Ansprüche 1 bis 5,
**dadurch gekennzeichnet, daß** die Umlaufgeschwindigkeit in der zweiten Stufe höher als 600 mm/s beträgt.

8. Verfahren nach einem der Ansprüche 1 bis 7,
**dadurch gekennzeichnet, daß** bei einem gewünschten Lochdurchmesser > 150 µm in der ersten Stufe ein zusätzlicher Kreis von Laserimpulsen auf den Bereich innerhalb des vom Laserstrahl (4) beschriebenen Kreises (D1) gerichtet wird.

9. Verfahren nach einem der Ansprüche 1 bis 8,
**dadurch gekennzeichnet, daß** zunächst für alle Löcher eines Bearbeitungsbereiches die erste Stufe ausgeführt wird, daß dann die Lasereinstellung verändert und die zweite Stufe für alle Löcher des Bereichs durchgeführt wird.

10. Verfahren zum Bohren von Mikro-Löchern (14)in einem Mehrschicht-Substrat (10) mit einer ersten (11) und mindestens einer zweiten (12) Metallschicht und mit jeweils einer zwischen zwei Metallschichten angeordneten Dielektrikumsschicht (13) durch Bestrahlung mit dem Energiestrahl eines Festkörperlasers (1) mit einer Wiederholfrequenz von mindestens 10 kHz, einer Wellenlänge von weniger als 1100 nm und einer Pulslänge von weniger als 50 ns, wobei die Bestrahlung in zwei Stufen derart erfolgt, daß in der ersten Stufe jeweils die erste Metallschicht und ein Teil der darunterliegenden Dielektrikumsschicht und daß in der zweiten Stufe die Dielektrikumsschicht sauber bis auf die zweite Metallschicht abgetragen wird, mit folgenden Schritten:
- in der ersten Stufe wird der Laserstrahl (4) auf eine Wiederholfrequenz von mindestens 15 kHz eingestellt, auf die erste Metallschicht (11) fokussiert und mit einer ersten Umlaufgeschwindigkeit in einem Kreis entsprechend dem Durchmesser (D1) des gewünschten Loches in so vielen Durchgängen bewegt, bis zumindest die erste Metallschicht (11) durchschnitten ist, wobei die Metallschicht im Lochbereich vollständig entfernt wird, und
- in der zweiten Stufe wird der Laserstrahl auf eine gleiche oder geringere Wiederholfrequenz wie in der ersten Stufe eingestellt und zentrisch auf die im Loch freigelegte Dielektrikumsschicht gerichtet, wobei der Strahl derart defokussiert wird, daß der von ihm bestrahlte Fleck mindestens so groß ist wie die Fläche des zu bohrenden Loches, derart, daß das in der ersten Stufe ausgeschnittene Loch in der Metallschicht als Maske wirkt.

11. Verfahren nach Anspruch 10,
**dadurch gekennzeichnet, daß** ein Neodymium-Vanadat-Laser mit einer Wellenlänge von 532 nm verwendet wird.

## Claims

1. Method for drilling micro-holes (14) in a multilayer substrate (10) having a first metal layer (11) and at least one second metal layer (12), and having a dielectric layer (13) in each case arranged between two metal layers, by irradiation with the energy beam of a solid-state laser (1) having a repetition frequency of at least 10 kHz, a wavelength of less than 1100 nm and a pulse length of less than 50 ns, the irradiation being carried out in two operations in such a way that, in the first operation, the first metal layer and a part of the underlying dielectric layer are in each case ablated and, in the second operation, the dielectric layer is ablated cleanly down to the second metal layer, having the following steps:
- in the first operation, the laser beam (4) is set to a repetition frequency of at least 15 kHz, focused onto the first metal layer (11) and moved with a first circumferential velocity in a circle corresponding to the diameter (D1) of the desired hole, in such a number of passes until at least the first metal layer (11) is cut through, the metal layer being fully removed in the hole region, and
- in the second operation, the laser beam (4) is set to an equal or lower repetition rate than in the first operation, directed out of focus onto the dielectric layer (13) exposed in the hole (14) and moved, with a circumferential velocity which is higher than the first, in one (D1) or more (D2) concentric circles inside the desired hole diameter, in such a number of passes until the dielectric layer is ablated in the hole region, the defocusing (s) and the second circumferential velocity being set in such a way that the effective energy density in the second operation lies below the threshold for ablation of the second metal layer.

2. Method according to Claim 1, **characterized in that** a neodymium vanadate laser having a wavelength of 355 nm is used.

3. Method according to Claim 1, **characterized in that** a neodymium vanadate laser having a wavelength of 532 nm is used.

4. Method according to Claim 1 or 2, **characterized in that** the repetition frequency in the first operation is set between about 15 kHz and about 40 kHz and, in the second operation, between about 10 kHz and 20 kHz, the repetition frequency in the second operation always being equal to or less than in the first operation.

5. Method according to one of Claims 1 to 4, **characterized in that** the repetition frequency is set to 15 kHz in both operations.

6. Method according to one of Claims 1 to 5, **characterized in that** the circumferential velocity of the laser beam (4) in the first operation is between 200 and 300 mm/s and, in the second operation, between 200 and 600 mm/s, but in any event higher than in the first operation.

7. Method according to one of Claims 1 to 5, **characterized in that** the circumferential velocity in the second operation is higher than 600 mm/s.

8. Method according to one of Claims 1 to 7, **characterized in that**, for a desired hole diameter > 150 µm, an additional circle of laser pulses is directed in the first operation onto the region inside the circle (D1) described by the laser beam (4).

9. Method according to one of Claims 1 to 8, **characterized in that** the first operation is firstly performed for all the holes of a processing region, **in that** the laser setting is then modified and the second operation is carried out for all the holes of the region.

10. Method for drilling micro-holes (14) in a multilayer substrate (10) having a first metal layer (11) and at least one second metal layer (12), and having a dielectric layer (13) in each case arranged between two metal layers, by irradiation with the energy beam of a solid-state laser (1) having a repetition frequency of at least 10 kHz, a wavelength of less than 1100 nm and a pulse length of less than 50 ns, the irradiation being carried out in two operations in such a way that, in the first operation, the first metal layer and a part of the underlying dielectric layer are in each case ablated and, in the second operation, the dielectric layer is ablated cleanly down to the second metal layer, having the following steps:
- in the first operation, the laser beam (4) is set to a repetition frequency of at least 15 kHz, focused onto the first metal layer (11) and moved with a first circumferential velocity in a circle corresponding to the diameter (D1) of the desired hole, in such a number of passes until at least the first metal layer (11) is cut through, the metal layer being fully removed in the hole region, and
- in the second operation, the laser beam is set to an equal or lower repetition rate than in the first operation and centrally directed onto the dielectric layer exposed in the hole, the beam being defocused in such a way that the spot irradiated by it is at least as large as the area of the hole to be drilled, in such a way that the hole cut out of the metal layer in the first operation acts as a mask.

11. Method according to Claim 10, **characterized in that** a neodymium vanadate laser having a wavelength of 532 nm is used.

## Revendications

1. Procédé pour percer des micro-trous (14) dans un substrat multicouche (10) comportant une première (11) et au moins une seconde (12) couche métallique et une couche diélectrique (13) disposée respectivement entre deux couches métalliques, par irradiation avec le rayon énergétique d'un laser à solide (1), à une fréquence de reproduction d'au moins 10 kHz, une longueur d'onde inférieure à 1100 nm et une longueur d'impulsion inférieure à 50 ns, l'irradiation s'effectuant en deux passes de telle sorte que lors de la première passe la première couche métallique et une partie de la couche diélectrique disposée sous celle-ci sont enlevées et que lors de la deuxième passe la couche diélectrique est enlevée proprement jusqu'à la seconde couche métallique selon les étapes suivantes :
- Lors de la première passe, le rayon laser (4) est réglé à une fréquence de reproduction d'au moins 15 kHz, focalisé sur la première couche métallique (11) et déplacé à une première vitesse de rotation dans un cercle correspondant au diamètre (D1) du trou souhaité en autant de passes qu'il est nécessaire pour découper au moins la première couche métallique (11), la couche métallique dans la zone du trou étant totalement éliminée, et
- lors de la seconde passe, le rayon laser (4) réglé à un taux de reproduction égal ou inférieur à celui de la première passe, dirigé de manière non focalisée sur la couche diélectrique (13) dégagée dans le trou (14) et déplacé à une vitesse de rotation supérieure à la première, dans un (D1) ou plusieurs (D2) cercle(s) concentrique(s) à l'intérieur du diamètre du trou souhaité en autant de passages que cela est nécessaire pour enlever la couche diélectrique dans la zone du trou, la défocalisation (s) et la seconde vitesse de rotation étant réglées de telle manière que la densité énergétique efficace lors de la seconde passe soit inférieure au seuil d'enlèvement de la seconde couche métallique.

2. Procédé selon la revendication 1,
**caractérisé en ce qu'**un laser au néodyme-vanadate d'une longueur d'onde de 355 nm est utilisé.

3. Procédé selon la revendication 1,
**caractérisé en ce qu'**un laser au néodyme-vanadate d'une longueur d'onde de 532 nm est utilisé.

4. Procédé selon la revendication 1 ou 2,
**caractérisé en ce que** la fréquence de reproduction lors de la première passe est réglée entre environ 15 kHz et environ 40 kHz, entre environ 10 kHz et 20 kHz lors de la seconde passe, la fréquence de reproduction lors de la seconde passe étant toujours égale ou inférieure à celle de la première passe.

5. Procédé selon l'une des revendications 1 à 4,
**caractérisé en ce que** la fréquence de reproduction dans les deux passes est réglée à 15 kHz.

6. Procédé selon l'une des revendications 1 à 5,
**caractérisé en ce que** la vitesse de rotation du rayon laser (4) comprise entre 200 et 300 mm/s dans la première passe et entre 200 et 600 mmls dans la seconde passe, est dans tous les cas supérieure à celle de la première passe.

7. Procédé selon l'une des revendications 1 à 5,
caractérisé en ce la vitesse de rotation lors de la seconde passe est supérieure à 600 mm/s.

8. Procédé selon l'une des revendications 1 à 7,
**caractérisé en ce qu'**avec un diamètre de trou souhaité > 150 µm lors de la première passe, un cercle supplémentaire d'impulsions laser est dirigé sur la zone se trouvant à l'intérieur du cercle (D1) décrit par le rayon laser (4).

9. Procédé selon l'une des revendications 1 à 8,
**caractérisé en ce que** la première passe est d'abord exécutée pour tous les trous d'une zone d'usinage, et **en ce que** le réglage du laser est ensuite modifié et la seconde passe est exécutée pour tous les trous de cette zone.

10. Procédé pour percer des micro-trous (14) dans un substrat multicouche (10) comportant une première (11) et au moins une seconde (12) couche métallique et une couche diélectrique (13) disposée respectivement entre deux couches métalliques, par irradiation avec le rayon énergétique d'un laser à solide (1), à une fréquence de reproduction d'au moins 10 kHz, une longueur d'onde inférieure à 1100 nm et une longueur d'impulsion inférieure à 50 ns, l'irradiation s'effectuant en deux passes de telle sorte que lors de la première passe la première couche métallique et une partie de la couche diélectrique disposée sous celle-ci sont enlevées et que lors de la deuxième passe la couche diélectrique est enlevée proprement jusqu'à la seconde couche métallique selon les étapes suivantes :
- Lors de la première passe, le rayon laser (4) est réglé à une fréquence de reproduction d'au moins 15 kHz, focalisée sur la première couche métallique (11) et déplacée à une première vitesse de rotation dans un cercle correspondant au diamètre (D1) du trou souhaité en autant de passes qu'il est nécessaire pour découper au moins la première couche métallique (11), la couche métallique dans la zone du trou étant totalement éliminée, et
- lors de la seconde passe, le rayon laser est réglé à une fréquence de reproduction égale ou inférieure à celle de la première passe, dirigé de manière centrée sur la couche diélectrique dégagée dans le trou, le rayon étant défocalisé de telle sorte que le spot irradié par celui-ci est au moins aussi grand que la surface du trou à percer, de telle sorte que le trou découpé dans la couche métallique lors de la première passe remplisse une fonction de masque.

11. Procédé selon la revendication 10,
**caractérisé en ce qu'**un laser au néodyme-vanadate d'une longueur d'onde de 532 nm est utilisé.
